Europäisches Patentamt

European Patent Office

Office européen des brevets

(11) Publication number: **0 217 538 B1**

# EUROPEAN PATENT SPECIFICATION

(45) Date of publication of patent specification: **07.10.92** (51) Int. Cl.⁵: **H05K 5/00**

(21) Application number: **86306646.0**

(22) Date of filing: **28.08.86**

(54) **A front loading apparatus.**

(30) Priority: **28.08.85 JP 190372/85**

(43) Date of publication of application:
**08.04.87 Bulletin 87/15**

(45) Publication of the grant of the patent:
**07.10.92 Bulletin 92/41**

(84) Designated Contracting States:
**BE DE FR GB IT LU NL SE**

(56) References cited:
**DE-A- 2 736 823**
**DE-A- 3 313 802**
**GB-A- 2 021 334**

(73) Proprietor: **NINTENDO CO. LIMITED**
**60, Fukuine Kamitakamatsu-cho**
**Higashiyama-ku Kyoto(JP)**

(72) Inventor: **Yukawa, Masayuki**
**147-17, Yodoshimozu-cho**
**Fushimi-ku Kyoto(JP)**

(74) Representative: **Arthur, Bryan Edward et al**
**Withers & Rogers 4 Dyer's Buildings Holborn**
**London EC1N 2JT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# Description

Field of the Invention

The present invention relates to a front loading apparatus. More specifically, the present invention relates to a front loading apparatus of a memory cartridge which can be utilized for data processing apparatuses such as home TV game machines and personal computers which perform processing based on the contents of a memory cartridge being loaded and unloaded freely.

Description of the Prior Art

In the data processing apparatuses as described above, a memory cartridge or a memory cassette is used which accommodates a non-volatile memory such as a ROM which stores various programs and data therein. Such a memory cartridge is constituted so as to be able to be loaded in or unloaded from the loading apparatus.

One example of the conventional memory cartridge and the loading apparatus which loads it is disclosed, for example, in the U.S. Patent No. 4,095,791 issued on June 20, 1978 or the like. Another example of a front loading apparatus, corresponding to the preamble of claim 1, is known from GB-A-2 021 334 published on November 28, 1979.

In this prior art, most of the memory cartridge is exposed out of the loading apparatus, and therefore a printed circuit board built in the memory cartridge acts as a sort of antenna, and accordingly this has a problem that spurious radiation is likely to be produced. Also, in the conventional loading apparatus, the edge of the above-described printed circuit board is press-inserted into a connector when inserting the memory cartridge, and therefore a connecting electrode formed on the edge is abraded easily, and thereby when loading and unloading are repeated frequently, metallic plating of the connecting electrode is worn off, resulting in a poor contact of the connector with the cartridge. Furthermore, the conventional apparatus requires a strong force to press-insert or pull the printed circuit board of the memory cartridge into or off the connector, and accordingly no little child can easily load or unload the memory cartridge.

## SUMMARY OF THE INVENTION

Therefore, an object of the present invention is to provide a novel front loading apparatus of a memory cartridge.

Another object of the present invention is to provide a front loading apparatus capable of suppressing abrasion of a connecting electrode formed on the edge portion of a printed circuit board of a memory cartridge.

Still another object of the present invention is to provide a front loading apparatus capable of easily loading or unloading a memory cartridge.

To be brief, the present invention is of a front loading apparatus according to claim 1.

When the front end part of the cartridge tray is rotated upward and is positioned at the top dead center, the memory cartridge can be inserted into the cartridge tray from the obliquely upper front of the loading apparatus. After the memory cartridge is inserted, the printed circuit board is inserted into the connector. Then, by pressing the cartridge and the front end part of the cartridge tray from the upper side, the cartridge tray is rotated downward. In this state, the holding member is locked by the locking means in the state of being kept in a predetermined positional relation with the frame structure. At this time, the surface of the edge of the printed circuit board of the memory cartridge is pushed against the connector, and a connecting electrode formed on the edge surface is press-contacted with a connecting electrode of the connector, and thereby the both electrodes are connected electrically.

In accordance with the present invention, the memory cartridge is loaded in the state that the whole thereof is inserted into the front loading apparatus. The connecting electrode of the printed circuit board of the memory cartridge and the connecting electrode of the connector are connected electrically by pressure-contact. Therefore, not only a strong force is not required for loading or unloading the memory cartridge, but also the loading or unloading of the memory cartridge becomes very easy. In addition, abrasion or peel-off of the metallic plated portion of the connecting electrode of the printed circuit board of the memory cartridge can be suppressed to a great extent, and thereby elongation of the service life of the memory cartridge can be realized.

These objects and other objects, feature, aspects and advantages of the present invention will become more apparent from the following detailed description of the embodiments of the present invention when taken in conjunction with accompanying drawings.

## BRIEF DESCRIPTION OF THE DRAWINGS

Fig. 1A and Fig. 1B are perspective views showing one example of a memory cartridge which can be loaded in a loading apparatus in accordance with the present invention.

Fig. 2 is a perspective view showing a home TV game machine as one example of a data processing apparatus wherein a front loading apparatus is incorporated in accordance with the present invention.

Fig. 3 is a perspective view showing one embodiment in accordance with the present invention.

Fig. 4 is a plan view of Fig. 3 embodiment.

Fig. 5 is a partly broken front view of Fig. 3 embodiment.

Fig. 6 is a side view of Fig. 3 embodiment.

Fig. 7 is a cross-sectional view taken along line VII-VII in Fig. 3.

Fig. 8 is a front view showing a major portion of a locking mechanism of Fig. 3 embodiment.

Fig. 9 is an illustrative view showing a state of accommodating Fig. 3 embodiment in the home TV game machine main unit as illustrated in Fig. 2.

Fig. 10 is a cross-sectional view showing a connector portion in detail.

DESCRIPTION OF THE PREFERRED EMBODIMENTS

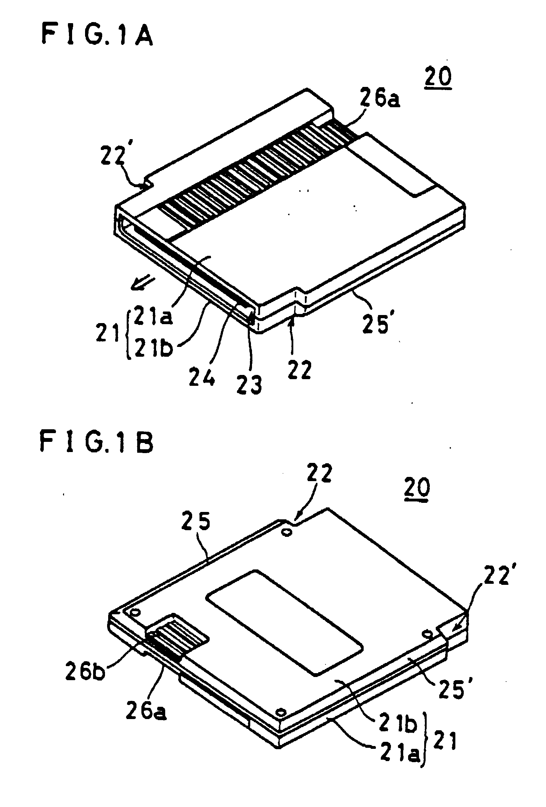

Fig. 1A and Fig. 1B are perspective views showing one example of a cartridge which can be loaded in or unloaded from a front loading apparatus in accordance with the present invention. A cartridge 20 comprises a case 21, and this case 21 is constituted with an upper half 21a and a lower half 21b. A rectangular opening 23 is formed at a front side of the case 21 in the direction of insertion (direction shown by an arrow in Fig. 1A), and a tip of a printed circuit board 24 accommodated in the case 21 is exposed inside the opening 23. In the case 21, a memory such as a ROM or a RAM is mounted on the printed circuit board 24 although not illustrated. If this cartridge 20 is employed for a video game apparatus, game programs, character data and the like will be stored in advance in such a memory.

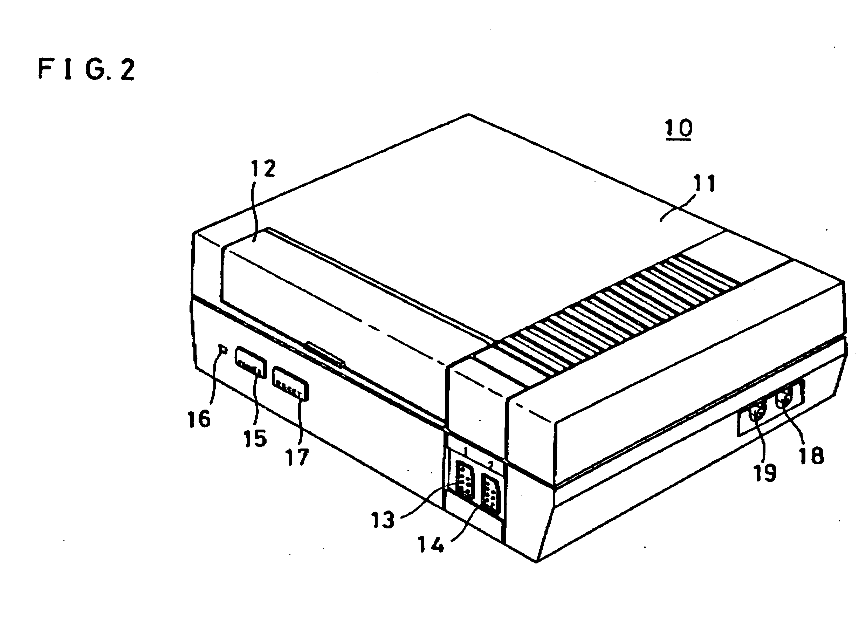

The cartridge 20 is inserted into a game machine main unit 10 as described later (Fig. 2) in the direction shown by the arrow in Fig. 1A with the upper half 21a thereof turned upward, that is, in the state as shown in Fig. 1A. Then, in the vicinity of the front side of the case 21 in the direction of insertion, stepped portions 22 and 22' are formed at the both sides thereof. By these stepped portions 22 and 22', the front side of the case 21 in the direction of insertion is formed in a narrow width and a portion of the case behind it is formed in a wide width. These stepped portions 22 and 22' act as stoppers for defining the amount of insertion of the cartridge 20, that is, the case 21 into the loading apparatus at a constant. A concave part 26a is formed at the rear end of the upper half 21a of the case 21 in the direction of insertion, and a concave part 26b is formed at the position of the lower half 21b corresponding to the concave part 26a. These concave parts 26a and 26b act as pinch portions in taking the cartridge 20 out of the game machine main unit 10 (Fig. 2). For this purpose, these concave parts 26a and 26b are desirably formed in a size large enough to be pinched by human fingers.

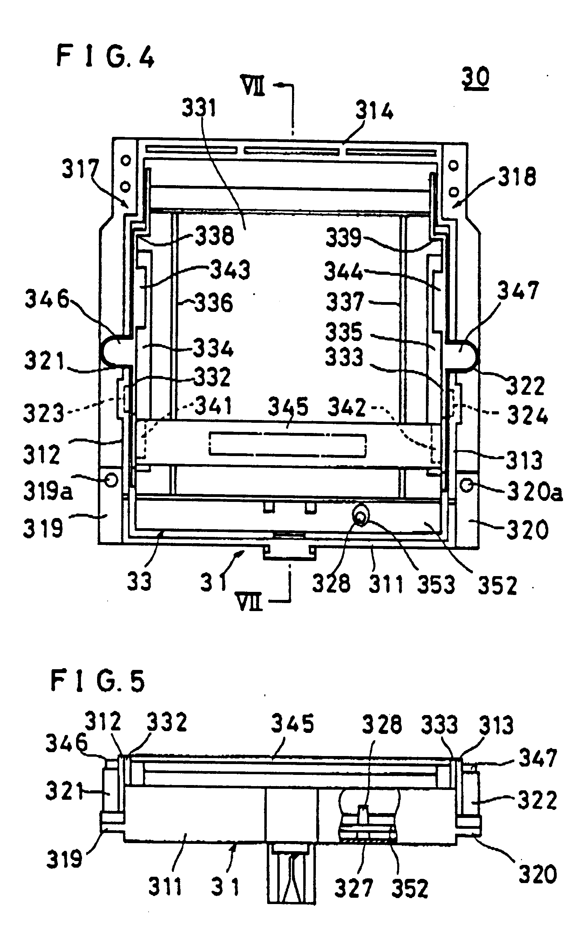

The concave part 26b of the lower half 21b also plays a role of inhibiting the normal loading of a cartridge other than an authentic or genuine one in the loading apparatus. To be detailed, the concave part 26b of the lower half 21b enables loading of only such an authentic cartridge that a concave part of a certain depth is formed at a position or part equivalent to the concave part 26b and checks a normal loading of a false cartridge having a shape other than this shape in cooperation with a cylindrical protrusion 328 as shown in Fig. 5 as described later. In addition, in the illustrated example, the concave part 26b serves also as a pinch portion, and therefore the area of the concave portion is formed considerably larger than the area of the tip of the cylindrical protrusion 328. However, the concave part 26b may be a small concave part or a through-hole wherethrough this protrusion 328 can be inserted or pulled out.

As is well understood from Fig. 1B, tapered portions or chamfered portions 25 and 25' having a certain incline are formed at both side ends of the bottom surface of the lower half 21b. These chamfered portions 25 and 25' are for preventing socalled "reverse insertion" that the cartridge 20 is loaded in a reverse fashion. Then, edge portions having a different shape from that of these chamfered portions 25 and 25' are formed at both sides of the top surface of the upper half 21a.

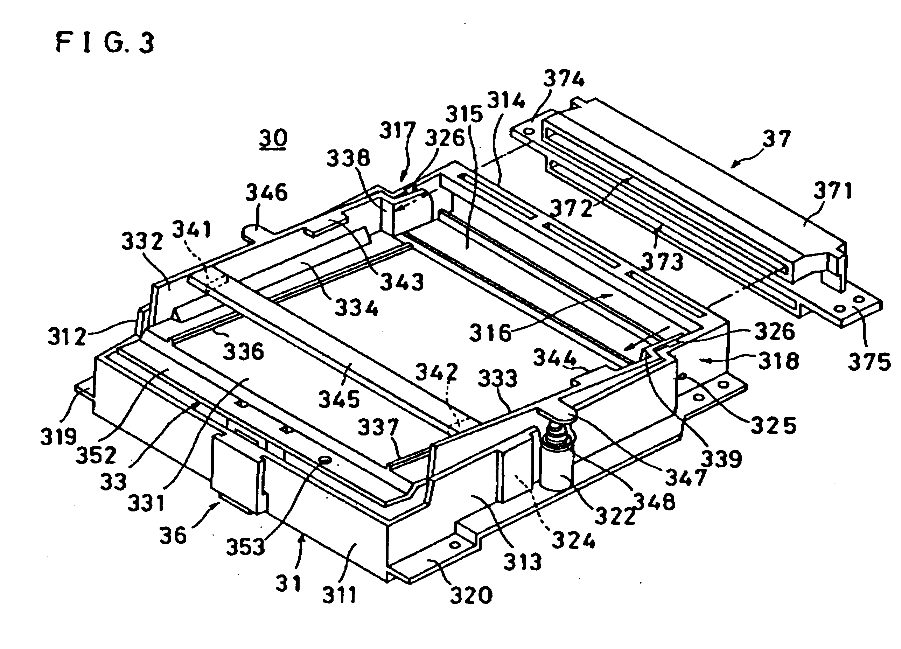

Such a cartridge 20 is inserted into the game machine main unit 10 as shown in Fig. 2. This main unit 10 comprises a case 11 which is formed by a conductive material such as metal. However, the case 11 may be formed by a non-conductive material such as plastics. A lid 12 is supported at the front end part of the top surface of the case 11 in a manner capable of opening and closing. Then, in the case 11, a front loading apparatus 30 is mounted which is described later in detail in reference to Fig. 3 through Fig. 8.

Jacks 13 and 14 are installed on the front surface of the case 11, and a controller (not illustrated) operated by an operator for game is connected by these jacks 13 and 14. Also, on the lower part of the front surface of the case 11, a power switch 15, a light emitting diode 16 for indicating turn-on of this power switch 15 and a reset switch 17 are installed. Furthermore, on the right side surface of the case 11, an external terminal for sound signal 18 and an external terminal for video signal 19 for giving signals to an image displaying apparatus, for example, a CRT (not illustrated) from this main unit 10.

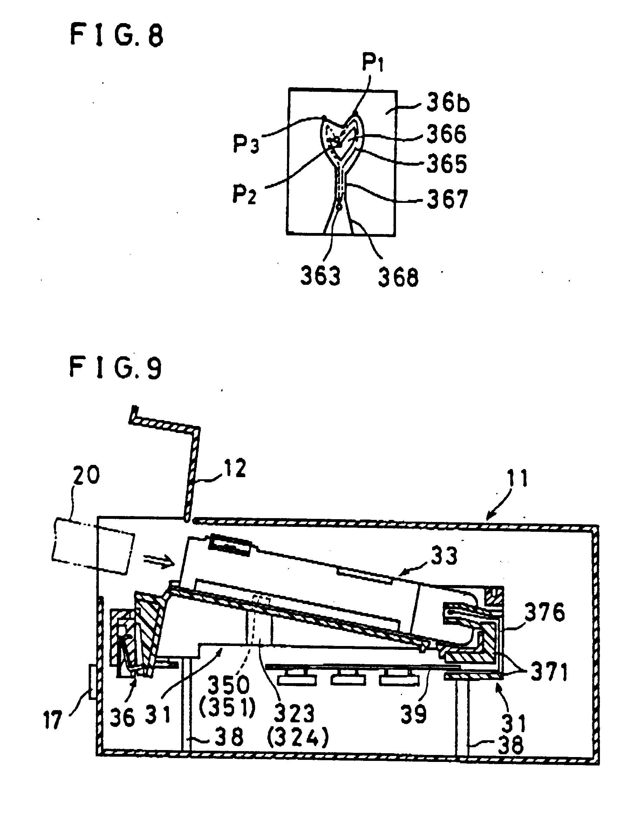

The front loading apparatus 30 comprises a frame 31 which is fixed in the case 11 (Fig. 2), for example, by screws through spacers 38 as shown in Fig. 9. The frame 31 is formed by a conductive material such as metal, being connected to the ground potential. However, the frame 31 may be formed by a non-conductive material such as plastics.

As shown in Fig. 3, the frame 31 has a front wall 311 formed on the front surface thereof and side walls 312 and 313 formed on the both sides thereof, and these side walls 312 and 313 are connected with each other by connecting parts 314 and 315 at the end parts thereof in the direction of depth (rear end parts). Between these connecting parts 314 and 315, a slender opening 316 is formed in a manner of extending in the horizontal direction so that an opening 372 at the upper side of a connector 37 can be inserted therein.

Vicinities of the rear end parts of the side walls 312 and 313 are bent inward so a to form L-shaped stepped portions 317 and 318. Also, brim parts 319 and 320 are formed on the outer surfaces of the side walls 312 and 313, and mounting holes 319a and 320a for fixing this frame 31 in the case 11 as illustrated in Fig. 9 as formed in these brim parts 319 and 320.

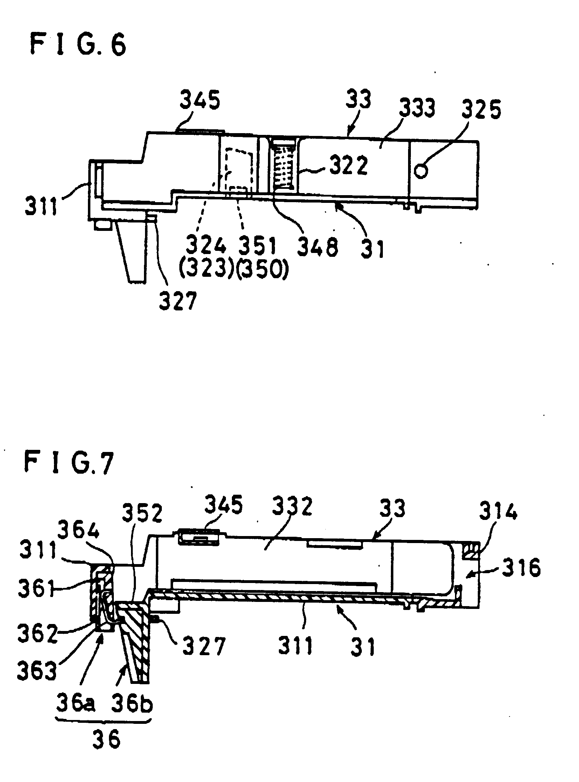

Top-opened cylindrical spring shoe parts 321 and 322 as well understood from Fig. 4 and Fig. 5 are formed on the outer surface of nearly central parts of the side walls 312 and 313 in the direction of insertion of the memory cartridge 20. In front of these spring shoe parts 321 and 322, engaging grooves 323 and 324 (Fig. 4) for defining the rotary angle range of a tray 33 as described later (Fig. 6) are formed on the inner surfaces of the side walls 312 and 313. These engaging grooves 323 and 324 are formed in a manner of extending to the position about two-thirds of the height thereof from the bottom ends of the side walls 312 and 313.

Then, shaft holes 325 (Fig. 3 and Fig. 6) wherethrough a shaft for rotatably supporting the tray 33 penetrates are formed respectively in the vicinities of the stepped portions 317 and 318 of the side walls 312 and 313, and at these positions, grooves 326 extending from the top end of the side walls 312 and 313 to the shaft holes 325 are formed. Thus, in the frame 31, the tray 33 for holding the inserted cartridge is supported by the shaft (not illustrated) penetrating through the shaft hole 325 so as to be able to rotate from the state of Fig. 7 to the state of Fig. 9. The front opening of the tray 33, that is, the port for inserting the cartridge 20 is located at the position of the lid 12 of the main unit 10 as described above, and accordingly the cartridge 20 can be inserted into the tray 33 can be pulled out therethrough.

The tray 33 is formed by a conductive material such as metal. However, the tray 33 may be formed by a non-conductive material such as plastics. The tray 33 comprises a bottom plate 331 and side walls 332 and 333 formed at both sides of the bottom plate 331. The shape and area of the part of the bottom plate 331 defined by the side walls 332 and 333 are selected to be nearly equal to the outside shape and area of the cartridge 20 loaded therein. This means that the tray 33 is constituted so that the whole of the cartridge 20, according, the case 21 can be accommodated or held in the space formed at the upper part thereof. Protruding rods 334 and 335 having a triangular cross-section are fixed to corner portions formed by jointing the bottom plate 331 and the side walls 332 and 333. The incline angles of these protruding rods 334 and 335 to the bottom plate 331 correspond to the incline angles of the above-described chamfered portions 25 and 25' of the cartridge 20 (Fig. 1B). Accordingly, the surfaces of these protruding rods 334 and 335 act as contacting surfaces with the chamfered portions 25 and 25'. This means that the "reverse insertion" of the cartridge 20 is prevented by the chamfered portions 25 and 25' and the protruding rods 334 and 335.

Protruding rods 336 and 337 having a rectangular or circular arc cross-section are disposed in a manner of extending in the insertion direction of the memory cartridge 20 on the top surface of the bottom plate 331 of the tray 33 in the vicinity of the side end of part thereof. These protruding rods 336 and 337 serve to reduce the contact resistance by preventing the back surface of the cartridge 20 inserted into the tray 33, that is, the surface of the lower half 12b from face-contacting with the bottom plate 331. Also, these protruding rods 336 and 337 act as reinforcing members of the bottom plate 331. This means that space for inserting the cartridge 20 can be secured enough by these protruding rods 336 and 337 even if some extend of warping takes place on the bottom plate 331 in the direction of depth thereof.

Stepped portions 338 and 339 corresponding to the side walls 312 and 313 of the frame 31 are formed at the rear end portions of the side walls 332 and 333 of the tray 33. These stepped portions 338 and 339 engage with the stepped portions 22 and 22' of the cartridge 20 to define the amount of insertion of the cartridge 20 at a constant value.

As is well understood from Fig. 3 and Fig. 4, protrusions protruding inside 341, 342, 343 and 344 are formed at the top ends of the side walls 332 and 333 of the tray 33. A gap from the bottom end surfaces of these protrusions 341 - 344 to the top end surface of the protrusions 336 and 337 is selected nearly equal to or a little larger than the thickness of the case 21 of the cartridge 20. Accordingly, the cartridge 20 is inserted between the protruding rods 336 and 337 and the protrusions 341 - 344. Then, the protrusions 341 - 344 play a role of preventing the cartridge 20 from coming upward off the tray 33 when rotating the tray 33 downward in the state that the cartridge 20 is inserted as described later.

A reinforcing plate 345 composed, for example, of metal of the like is mounted on a pair of protrusions 341 and 342 in front. This reinforcing plate 345 connects the side walls 332 and 333 to prevent the bottom plate 331 from warping. Also, if the cartridge 20 is inserted in the state that the tray 33 is pushed-in downward, the reinforcing plate 345 strikes against the front of the cartridge 20, and therefore insertion of the cartridge 20 in such a state can be checked.

If the reinforcing plate 345 is composed of a conductive material and is connected electrically to the frame 31, the reinforcing plate 345 acts also as a discharging means for discharging charges charged on the case 21 in inserting the cartridge 20. This means that when the cartridge 20 is inserted into the tray 33, the surface of the upper half 21a of the case 21 is brought in contact with the reinforcing plate 345. Then, the charges stored on the case 21 are discharged to the potential of the frame 31, that is, the ground potential through this reinforcing plate 345. Accordingly, electric bombardment onto electronic components (not illustrated) mounted on the printed circuit board 24 in the case 21 is prevented, and these electronic components are protected effectively from static electricity.

At the top end parts of the side walls 332 and 333 of the tray 33, spring stop pieces 346 and 347 are formed in an outside-protruded manner at the positions of the spring shoe parts 321 and 322 installed on the side walls 312 and 313 of the frame 31. Coil springs 348 are held respectively in the spring shoe parts 321 and 322 by these spring stop pieces 346 and 347. As described above, the tray 33 is supported by the shaft (not illustrated) penetrating through the shaft holes 325 so as to be rotatable around this shaft, and therefore normally the tray 33 is elastically energized upward by these coil springs 348. Then, engaging protrusions 350 and 351 (Fig. 6 and Fig. 9) for defining the upper limit of upward rotation of the tray 33 by the springs 348 are formed on the outer surface of the side walls 332 and 333 facing the engaging grooves 323 and 324 formed on the inner surfaces of the side walls 312 and 313 of the frame 31. The state that the tray 33 is rotated to the upward limit is a state that the cartridge 20 can be inserted into or pulled off the tray 33.

At the front end of the bottom plate 331 of the tray 33, a stepped portion 352 is formed in a manner of stepping down the bottom plate 331, and a through-hole 353 is formed at a predetermined position of this stepped portion 352. Inside the front wall 311 of the frame 31, a holding plate 327 is formed under the stepped portion 352 thereof. A cylindrical protrusion 328 is formed in an upright fashion at a predetermined position on this holding plate 327. The outer diameter of the cylindrical protrusion 328 is a little smaller than the inner diameter of the through-hole 353. Also, the height of the cylindrical protrusion 328 is selected so that the top end thereof protrudes beyond the top surface of the bottom plate 331 by a length equivalent to the depth of the concave part 26b (Fig. 1B) of the lower half 21b. Then, the cylindrical protrusion 328 is formed at the position where it faces the concave part 26b when the cartridge 20 is inserted into the tray 33. Accordingly, the tray 33 is allowed to rotate downward until the concave face of the concave part 26b contacts with the top end of the cylindrical protrusion 328. Thereby, the normal loading of the cartridge 20 is made possible. If a cartridge whereon no concave part 26b is formed is inserted, the top end of the cylindrical protrusion 328 contacts with the back surface of the cartridge, and thereby the downward rotation of the tray 33 is checked. Thus, the cylindrical protrusion 328 plays a role of inhibiting loading of a cartridge of a shape other than predetermined, that is, a false cartridge in cooperation with the concave part 26b of the lower half 21b.

Furthermore, a locking mechanism 36 is installed in association with the front wall 311 of the frame 31 and the stepped portion 352 of the bottom plate 331 of the tray 33. This locking mechanism 36 is installed on the front wall 311 as shown in Fig. 7 and Fig. 8, and comprises a key mechanism 36a equivalent to a key and a cam mechanism 36b which is installed under the stepped portion 352 of the front end of the bottom plate 331 of the tray 33 and is equivalent to a lock.

As shown in Fig. 7, the key mechanism 36a comprises an engaging groove 361 formed on the back side of the front wall 311, and a plate spring 362 is fixed to this engaging groove 361. Then, a hook-shaped or U-shaped hook pin 363 is energized to the cam mechanism 36b side by this plate spring 362. Furthermore, a holding piece 364 supports the top end of the hook pin 363 in a fixed fashion and the bottom end thereof in a manner capable of swinging.

As shown in Fig. 8, the cam mechanism 36b comprises a heart-shaped groove 365 which is a little wider than the thickness of the above-mentioned hook pin 363 and is formed in a heart shape as a whole at somewhat upper portion from the center thereof. An engaging protrusion 366 is formed by an island part surrounded by this heart-shaped groove 365. Also, a groove 367 is formed which extends downward from the bottom end of the heart-shaped groove 365, and a trumpet-shaped groove 368 is formed at a further lower position from this groove 367.

Normally the tray 33 is kept in the state as shown in Fig. 9 by the coil spring 348. Then, when the cartridge 20 is loaded, it is inserted into the space which is defined by the bottom plate 331 and the side walls 332 and 333 of the tray 31 in the state that the front end thereof is lifted upward. Thereafter, this tray 33 is pushed down against the spring force of the coil spring 348. At this time, since the top end of the hook pin 363 is supported in a fixed fashion by the holding piece 364, the cam mechanism 36b is guided by the bottom end of the hook pin 363, the trumpet-shaped groove 368, the groove 367 and the heart-shaped groove 365 on the right of the engaging protrusion 366. This means that the cam mechanism 36b displaces so that the bottom end of the hook pin 363 moves in the heart-shaped groove 365 and depicts a locus as shown by a dash-dot line in Fig. 8, and accordingly, the bottom end of the hook pin 363 is brought to the position of a point P1 as shown in Fig. 8. Thereafter, when the pushing pressure from the upside of the tray 33 is weakened, this tray 33 is restored upward by an elastic force of the coil spring 348. Then, the bottom end of the hook pin 363 engages with a U-shaped concave part of the top side of the engaging protrusion 366, that is, a portion as shown by a point P2 in Fig. 8, and thereby the tray 33 is locked. This means that the tray 33 holds the downward-pushed state as illustrated in Fig. 7.

On the other hand, when the cartridge 20 is taken out, the tray 33 in the state of Fig. 7 is pushed downward again. Then, a point P3 (Fig. 8) of the heart-shaped groove 365 reaches the bottom end of the hook pin 363. With weakening the pushing pressure from the upper side of the tray 33, the bottom end of the hook pin 363 moves along the heart-shaped groove 365 on the left of the engaging protrusions 336, the groove 367 and the trumpet-shaped groove 368, being brought to the bottom end of this trumpet-shaped groove 368. This means that the bottom end of the hook pin 363 moves so as to depict a locus as shown by a dotted line in Fig. 8, and thereby the locked state of the tray 33 is released.

As is described above, in the cam-system locking mechanism 36 of this embodiment, the tray 33 is locked by a first push, and the locking thereof is released by a second push to restore to the normal state. However, it is possible of course that such a locking mechanism is constituted with a lever or the like, and the lock by the lever is released in interlocking with an operation of an eject button (not illustrated).

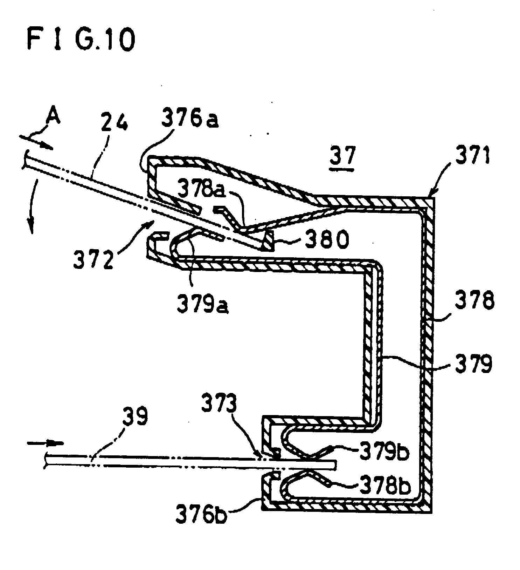

As shown in Fig. 3, an opening 372 of the connector 37 is engaged with the opening 316 of the rear end of the frame 31. The connector 37 comprises a case 371 which has a U-shaped side surface as shown in Fig. 9 and is oblong when viewed from the front, and in front of this case 371, the above-described two openings 372 and 373 are formed up and down with an interval kept. As is well understood from Fig. 10, the edge portions of the printed circuit board 24 of the cartridge 20 and a printed circuit board 39 of the game machine main unit 10 are inserted respectively into these openings 372 and 373, and these printed circuit boards 24 and 39 are connected electrically.

To be described in further detail, as shown in Fig. 9 and Fig. 10, the front end of the top side of the case 371 protrudes forward beyond the front end of the bottom side thereof, and accordingly, the opening 372 is located forward from the opening 373. Then, the printed circuit board 24 of the caridge 20 is inserted obliquely into the opening 372. For this purpose, the tip of a top-side open and 376a defining the opening 372 is bent inward in a slant fashion. On the other hand, the tip of a bottom-side opening end 376b defining the opening 373 is bent in a nearly horizontal fashion.

A large number of pairs of spring electrodes 378 and 379 having a U-shaped side cross-section are accommodated in the case 371. These spring electrodes 378 and 379 are arranged respectively in the direction of width of this connector 37 with a constant interval kept in a manner of plural pairs. Grooves or partitions (not illustrated) are preferably formed on the inner surface of the case 371 to dispose such spring electrodes 378 and 379 at a constant interval. Then, the respective bottom-side open ends of the spring electrodes 378 and 379 are bent inward in a U-shaped fashion, being formed as contact parts 378b and 379b facing each other.

Also, the top-side open end of the spring electrode 379 is bent inward in a U-shaped fashion to form a contact part 378a, and the top-side open end of the spring electrode 378 is bent outward in a V-shaped fashion in the vicinity of the opening 372, and the tip thereof is further folded back in a V-shaped fashion, thereby a contact part 379a is formed. These contact parts 378a and 379a are located so as to shift from each other in the direction of insertion of the printed circuit board 24 as shown by an arrow A, and an interval equal to or somewhat larger than the thickness of the printed circuit board 24 is created between the both when viewed from an obliquely upper position where the cartridge 20 is inserted. Then, a stopper 380 for defining the depth of the printed circuit board 24 is formed at a position which is deeper than and under the contact part 378a. The reason why the contact parts 378a and 379a are disposed in the direction of insertion of the printed circuit board 24 with an interval kept in such a manner is to facilitate the loading of the printed circuit board 24, that is, the cartridge 20.

To be detailed, when the cartridge 20 is loaded, the printed circuit board 24, that is, the cartridge 20 is inserted until the tip of the printed circuit board 24 of the cartridge 20 strikes against the stopper protrusion 381, and thereafter the front end of the printed circuit board 24 is pushed downward against the coil spring 348 to a position where the printed circuit board 24 becomes parallel with the printed circuit board 39 with the contact part 379a acting as a fulcrum, and thereby connecting electrodes (not illustrated) formed on one or both surfaces of the edge portion of the printed circuit board 24 are brought in pressure-contact with the contact part 378a and/or 379a. Thus the printed circuit board 24 of the cartridge 20 is simply slid between the electrodes 378 and 379 of the connector 37.

When a game is performed using the game machine main unit 10 (Fig. 2), first the sound external terminal 18 and the video external terminal 19 are connected to a CRT (not illustrated) such as a home TV set. Thereafter, the lid 12 is opened, and the cartridge 20 is inserted into the tray 33 with the lower half 21b thereof positioned downward (Fig. 7). At this time, the stepped portions 22 and 22' of the cartridge 20 engage with the stepped portions 338 and 339 of the tray 33, and thereby the amount of insertion of the cartridge 20 is defined. However, the whole of the cartridge 20 is put on the tray 33. Then, the top-side opening 372 of the case 371 of the connector 37, that is, the whole of the top-side open end 376a engages with the inside of the opening 23 (Fig. 1A) of the case 21 of the cartridge 20. As shown in Fig. 10, this is not the normal state of loading of the printed circuit board 24 of the cartridge 20, but the printed circuit board 24 of the cartridge 20 has a predetermined incline angle, for example, an incline angle of about 10° with respect to the printed circuit board 39 of the game machine unit 10, and therefore the spring electrodes 378 and/or 379 and the connecting electrode of the printed circuit board 24 are not in the state of complete contact.

Subsequently, the cartridge 20, that is, the tray 33 is pushed down from the upper side. At this time, when a predetermined-shaped, that is, authentic cartridge has been inserted, the tray 33 is pushed downward, and the locking mechanism 36 locks the tray 33 to the frame 31 in the horizontal state as described in reference to Fig. 8. Accordingly, as described previously, the connecting electrodes of the printed circuit board 24 are brought in press-contact with those corresponding to the spring electrodes 378 and/or 379 in the top-side opening 372 of the connector 37, and these are put in the state of complete contact, being connected electrically. Thereafter, the lid 12 (Fig. 2) is closed, and the game can be performed using a controller (not illustrated).

When a cartridge wherein no concave part 26b (Fig. 1B) is formed, that is, a false cartridge is inserted on the tray 33, the tray 33 cannot be pushed downward because the cylindrical protrusion 328 (Fig. 6) strikes against the back surface of the cartridge, and thereby the false cartridge cannot be loaded.

When the game ends, or when another kind of game is intended to be performed in the middle of the game, the lid 12 is opened and the front end portion of the memory cartridge 20 has only to be pushed downward. Then, the locked state by the locking mechanism 36 is released, and the tray 33 is rotated upward by the coil spring 348 to restore to the state as shown in Fig. 9. Then, the user pinches the concave parts 26a and 26b of the memory cartridge 20 by fingers, taking the memory cartridge 20 out of the loading apparatus 30, that is, the game machine main unit 10.

## Claims

1. A front loading apparatus for an electronic games machine adapted for use with a memory cartridge (20) of the type having a printing circuit board (24) built in a case (21) and that has a first plurality of exposed electrical contacts spaced along one board edge exposed out of said case, said apparatus comprising:

a main unit (10) containing a printed circuit board (39) having a second plurality of electrical contacts;

a cartridge tray (33) pivotally mounted on a frame (31) structure of said main unit for a rotation within a predetermined angular range by journaling the rear end portion of said frame structure between an upward cartridge loading and a downward cartridge operating position, and having an opening at one end located at the front of the main unit and adapted to slideably receive the cartridge and can hold the cartridge in the state that the whole of said case is inserted when the tray is in said cartridge loading position;

spring means (348) biasing said cartridge tray at the front end upwardly toward said cartridge loading position with the portion journaled by said frame structure centered;

releasable locking means (36) for locking said cartridge tray against said spring biasing means in said cartridge operating position and

a connector (37) mounted within said main unit, characterised in that said connector (37) is an edge connector with a connector housing (371) having two elongate openings (372,373), the main unit printed circuit board (39) being received in one of said elongate openings (373) and the other of said elongate openings (372) being adapted to receive an exposed printed circuit board edge of a memory cartridge (20), a plurality of spring electrodes (378,379) being disposed within said connector housing for electrically interconnecting said first and second plurality of electrical contacts, said spring electrodes being vertically opposed within said other elongate opening (372) and mutually offset in the direction of insertion of a cartridge such that the upper spring electrode (378) in said other opening is offset in said direction relative to the lower spring electrode (379) in said other opening (372).

2. A front loading apparatus according to claim 1 wherein the tray (33) includes a bottom plate (331), a pair of opposing side walls (332,333) adjoining the bottom plate and means (341-344) attached to the side walls for limiting the upward movement of a memory cartridge (20) with respect to the tray (33).

3. A front loading apparatus according to claim 1 or claim 2 wherein the connector housing (371) has an upper portion containing said other opening (372) and wherein the cartridge tray (33) includes a rear connecting member (314,315) extending between the side walls (332,333) and defining an opening (316) adapted to receive an upper portion of said connector housing (37).

4. A front loading apparatus according to any preceding claim wherein the spring means includes a coil spring (398) extending between the frame (31) and the cartridge tray (33) and a spring shoe (321,322) in which the spring is seated.

5. A front loading apparatus according to any preceding claim wherein the cartridge tray (33) includes a rail (336,337) extending in the direction of insertion of a memory cartridge for supporting the cartridge (20).

6. A front loading apparatus according to any preceding claim wherein the releasable locking means (36) includes a key mechanism comprising a resilient hook pin (363) and a cooperating cam mechanism (36b) comprising a groove (365) which defines the path of the pin when the key and cam mechanisms are engaged.

7. An electronic games machine comprising a front-loading apparatus as claimed in any preceding claim.

8. An electronic games machine according to claim 7 having a memory cartridge (20) loaded in said tray (33), said memory cartridge having a memory mounted on a first printed circuit board (24), said first printed circuit board being housed in a case (21) of the memory cartridge and having an edge portion which protrudes from said case and carries a first plurality of exposed electrical contacts which are in contact with said vertically opposed spring electrodes (378,379) in said other elongate opening (372), the whole of said memory cartridge case being inserted in said tray.

9. A games machine according to claim 8 wherein the memory cartridge case (21) has opposing stepped portions (22,22') and wherein opposing sides of the tray (33) include stepped segments (338,339) cooperating with the stepped portions of the case to limit the distance to which the cartridge (20) can be inserted in the tray.

10. A games machine according to claim 8 or claim 9 wherein the lower spring electrode (379) in said other opening (372) acts as a fulcrum on which said first printed circuit board (24) pivots as said tray (33) containing the memory cartrdige (20) is rotated between said cartridge loading position and said cartridge operating position.

11. An electronic games machine according to any of claims 7 to 10 wherein said case (21) has a chamfered portion (25,25') one side thereof, the cross-section of the opposite side of said case, when inverted, being different from the cross section of the side having said chamfered portion and said cartridge tray (33) having an inclined interior portion (334,335) which has a complementary incline to said chamfered position and thereby prevents inverted insertion of the memory cartridge (20) in the cartridge tray.

12. An electronic games machine according to any of claims 7 to 11 wherein said main unit (10) has an upwardly extending protrusion (328) which extends within a recess (26b) in the bottom surface of said case (21) when the cartridge tray (33) containing said memory cartridge (20) is in the catridge operating position, thereby preventing the use of an unauthorised cartridge not having such a recess.

**13.** An electronic games machine according to claim 12, wherein said protrusion (328) extends through an aperture (353) in said cartridge tray (33).

**14.** An electronic games machine according to claim 12 or claim 13 wherein a further recess (26a) is formed in the top surface of said case (21) opposite said first mentioned recess (26b), said recesses forming pinch portions which can be pinched between human fingers to facilitate insertion of said memory cartridge (20).

**15.** An electronic games machine according to any of claims 7 to 13 wherein said case (21) has stepped portions (22, 22') in opposite sides thereof which cooperate with complementary stepped portions (338,339) in said cartridge tray (33) to limit the degree of insertion of said memory cartridge (20) in said cartridge tray.

**Patentansprüche**

**1.** Frontladevorrichtung für eine elektronische Spielvorrichtung zur Verwendung mit einer Speicherkarte (20) eines Types, der eine in einem Gehäuse (21) eingebaute gedruckte Leiterplatte (24) besitzt und der eine erste Anzahl von freiliegenden und abstandsweise angeordneten elektrischen Kontakten entlang einer Plattenkante außerhalb des Gehäuses aufweist, wobei die Vorrichtung umfaßt:
eine Haupteinheit (10), die eine gedruckte Leiterplatte (39) mit einer zweiten Anzahl von elektrischen Kontakten enthält;
ein Kartenfach (33), das schwenkbar auf einer Rahmenstruktur (31) der Haupteinheit motiert ist, um eine Verschwenkung innerhalb eines vorgegebenen Winkelbetrages zwischen einer oberen Kartenbestückungsposition und einer unteren Arbeitsposition zu ermöglichen und das eine Öffnung an einem Ende aufweist, welches an der Vorderseite der Haupteinheit angeordnet ist und zum Einführen der Karte durch Verschwenken des hinteren Endbereiches der Rahmenstruktur vorgesehen ist, wenn sich das Fach in der Kartenbestückungsposition befindet und die Karte derart halten kann, daß sie insgesamt in das Gehäuse eingesetzt ist;
Federelemente (348), die das Kartenfach am vorderen Ende aufwärts in die Kartenbestückungsposition bewegen, wobei der geschwenkte Teil durch die Rahmenstruktur zentriert wird;

lösbare Verschlußmittel (36) zum Arretieren des Kartenfaches gegen Federelemente in der Arbeitsposition der Karte und
einem Verbinder (37), der innerhalb der Haupteinheit montiert ist, **dadurch gekennzeichnet,** daß der Verbinder (37) ein Randverbinder mit einem Verbindergehäuse (371) mit zwei länglichen Öffnungen (372, 373) ist, daß die gedruckte Leiterplatte (39) der Haupteinheit (10) in eine der länglichen Öffnungen (373) eingesetzt ist und die andere längliche Öffnung (372) zur Aufnahme einer freiliegenden Kante einer gedruckten Leiterplatte einer Speicherkarte (20) dient, daß eine Anzahl von Federkontakten (378, 379) innerhalb des Verbindergehäuses zur elektrischen Verbindung der ersten und der zweiten Anzahl von elektrischen Kontakten angeordnet sind, wobei die Federkontakte innerhalb der anderen länglichen Öffnung (372) einander gegenüberliegen und beidseitig in Einsetzrichtung einer Karte ausweichen, so daß der obere Federkontakt (378) der anderen Öffnung in der genannten Richtung bezüglich des unteren Federkontaktes (379) in der anderen Öffnung (372) ausweicht.

**2.** Frontladevorrichtung gemäß Anspruch 1, **dadurch gekennzeichnet,** daß das Fach (33) eine Grundplatte, ein Paar von gegenüberliegenden Seitenflächen (332, 333), die an die Grundplatte angrenzen, und Mittel (341 bis 344) enthält, die an den Seitenflächen zur Begrenzung der Aufwärtsbewegung einer Speicherkarte (20) hinsichtlich des Faches (33) angeordnet sind.

**3.** Frontladevorrichtung nach den Ansprüchen 1 oder 2, **dadurch gekennzeichnet,** daß das Verbindergehäuse (371) einen oberen Teil besitzt, der die obere Öffnung (372) enthält, in der das Kartenfach (33) ein hinteres Verbindungsmittel (314, 315) aufweist, welches sich zwischen den Seitenflächen (332, 333) erstreckt und eine Öffnung (316) zur Aufnahme eines oberen Teiles des Verbindungsgehäuses (37) begrenzt.

**4.** Frontladevorrichtung nach einem der vorstehenden Ansprüche, **dadurch gekennzeichnet,** daß das Federelement eine Schraubenfeder (398) aufweist, die sich zwischen dem Rahmen (31) und dem Kartenfach (33) sowie einem Federschuh (321, 322), in dem die Feder eingesetzt ist, erstreckt.

**5.** Frontladevorrichtung nach einem der vorstehenden Ansprüche, **dadurch gekennzeichnet,** daß das Kartenfach (33) eine Bahn (336, 337) enthält, die sich in Richtung des Einsetzens einer Speicherkarte zur Aufnahme der Karte (20) erstreckt.

6. Frontladevorrichtung nach einem der vorstehenden Ansprüche, **dadurch gekennzeichnet,** daß am lösbaren Verschlußmittel (36) ein Schließmechanismus mit einem elastischen Hakenelement (336) und einem mit diesem zusammenarbeitenden Nockenmechanismus (36b) angeordnet ist, der eine Aussparung (365) aufweist, die den Weg des Elementes definiert, wenn sich das Schloß und der Nockenmechanismus berühren.

7. Elektronische Spielvorrichtung, die eine Frontladevorrichtung, wie in einem der vorstehenden Ansprüche beansprucht, enthält.

8. Elektronische Spielvorrichtung nach Anspruch 7, **dadurch gekennzeichnet,** daß eine in das Fach (33) eingeführte Speicherkarte (20) einen Speicher aufweist, welcher auf einer ersten gedruckten Leiterplatte (24) montiert ist, daß die erste gedruckte Leiterplatte in einem Gehäuse (21) der Speicherkarte untergebracht ist und einen Kantenbereich aufweist, der aus dem Gehäuse hervorsteht und eine erste Anzahl von freiliegenden elektrischen Kontakten trägt, die in Kontakt mit den vertikal gegenüberstehenden Federkontakten (378, 379) in der anderen länglichen Öffnung (372) stehen, wobei das gesamte Speicherkartengehäuse in das Fach eingesetzt ist.

9. Spielvorrichtung nach Anspruch 8, **dadurch gekennzeichnet,** daß das Speicherkartengehäuse (21) sich gegenüberliegende abgestufte Bereiche (22, 22') aufweist und daß die so gegenüberliegenden Seiten des Faches (33) abgestufte Bereiche (338, 339) enthalten, die mit den abgestuften Bereichen des Gehäuses zusammenwirken, um den Weg, mit dem die Karte (20) in das Fach eingsetzt werden kann, zu begrenzen.

10. Spielvorrichtung nach Anspruch 8 oder 9, **dadurch gekennzeichnet,** daß der untere Federkontakt (379) in der anderen Öffnung (372) als Drehpunkt wirkt, um den sich die erste gedruckte Leiterplatte (24) schwenkt, wenn das die Speicherkarte (20) enthaltende Fach (33) zwischen der Kartenladestellung und der Arbeitsposition der Karte gedreht wird.

11. Elektronische Spielvorrichtung nach einem der Ansprüche 7 bis 10, **dadurch gekennzeichnet,** daß das Gehäuse (21) an seinen Seiten abgeschrägte Teile (25, 25') aufweist, wobei sich der Querschnitt der sich gegenüberliegenden Seiten dieses Gehäuses, wenn es umgedreht wird, vom Querschnitt der Seiten, die den abgestuften Teil aufweisen, unterscheidet und daß das Kartenfach (33) einen abgeschrägten Innenteil (334, 335) besitzt, der eine Abschrägung aufweist, die zum abgestuften Teil komplementär ist.

12. Elektronische Spielvorrichtung nach einem der Ansprüche 7 bis 11, **dadurch gekennzeichnet,** daß an der Haupteinheit (10) eine nach oben vorstehendenr Vorsprung (328) angeordnet ist, der sich innerhalb einer Vertiefung (26b) in der unteren Oberfläche des Gehäuses (21) erstreckt, wenn sich das die Speicherkarte (20) enthaltende Kartenfach (33) in der Kartenarbeitsposition befindet, wodurch die Verwendung einer nichtautorisierten Karte, die eine derartige Vertiefung nicht aufweist, verhindert wird.

13. Elektronische Spielvorrichtung nach Anspruch 12, **dadurch gekennzeichnet,** daß der Vorsprung (328) durch eine Öffnung (353) im Kartenfach (33) ragt.

14. Elektronische Spielvorrichtung nach Anspruch 12 oder 13, **dadurch gekennzeichnet,** daß eine weitere Vertiefung (26a) in der oberen Fläche des Gehäuses (21) gegenüber der zuerst genannten Vertiefung (26b) ausgebildet ist, wobei die Vertiefungen Griffelemente bilden, die zwischen menschlichen Fingern erfaßt werden können, um das Einsetzen der Speicherkarte (20) zu erleichtern.

15. Elektronische Soielvorrichtung nach einem der Ansprüche 7 bis 13, **dadurch gekennzeichnet,** daß das Gehäuse (21) abgestufte Teile (22, 22') an deren sich gegenüberliegenden Seiten aufweist, die mit komplementären abgestuften Teilen (338, 339) in dem Kartenfach (33) zusammenwirken, um den Einführweg der Speicherkarte (20) in das Kartenfach zu begrenzen.

**Revendications**

1. Dispositif de chargement frontal pour une machine de jeux électroniques destinée à être utilisée avec une cartouche à mémoire (20) du type comportant une carte de circuit imprimé (24) montée dans une boîte (21) et comportant un premier ensemble de contacts électriques espacés et exposés le long d'un bord de la carte sortant à l'extérieur de la boîte, ce dispositif comprenant :

un bloc principal (10) contenant une carte de circuit imprimé (39) munie d'un second ensemble de contacts électriques ;

un casier de cartouche (33) monté en pivotement sur une structure de châssis (31) du bloc principal de manière à tourner dans une plage angulaire prédéterminée, par montage en rotation de la partie d'extrémité arrière de cette structure de châssis entre une position haute de chargement de la cartouche et une position basse de fonctionnement de la cartouche, ce casier comportant, à une extrémité, une ouverture venant en face du bloc principal et destinée à recevoir en glissement la cartouche tout en pouvant maintenir cette cartouche dans une position telle que toute la boîte soit introduite lorsque le casier se trouve dans la position de chargement de la cartouche ;

des moyens de ressort (348) poussant le casier de cartouche à son extrémité avant de manière à le faire monter dans la position de chargement de la cartouche tandis que la partie montée en rotation par la structure de châssis est centrée ;

des moyens de verrouillage libérables (36) destinés à verrouiller le casier de cartouche, contre les moyens de poussée à ressort, dans la position de fonctionnement de la cartouche ; et

un connecteur (37) monté à l'intérieur du bloc principal ; dispositif de chargement frontal caractérisé en ce que le connecteur (37) est un connecteur de bord muni d'une boîte de connecteur (371) comportant deux ouvertures allongées (372, 373), la carte de circuit imprimé (39) au bloc principal venant se loger dans l'une des ouvertures allongées (373) et l'autre ouverture allongée (372) étant destinée à recevoir un bord exposé d'une carte de circuit imprimé d'une cartouche à mémoire (20), un certain nombre d'électrodes de ressorts (378, 379) étant disposées à l'intérieur de la boîte de connecteur pour brancher électriquement le premier ensemble de contacts électriques au second ensemble de contacts électriques, ces électrodes de ressorts étant opposées verticalement à l'intérieur de l'autre ouverture allongée (372) et mutuellement décalées dans la direction d'introduction d'une cartouche, de façon que l'électrode de ressort supérieure (378) se trouvant dans l'autre ouverture, soit décalée dans ceite direction par rapport à l'électrode de ressort inférieure (379) se trouvant dans l'autre ouverture (372).

2. Dispositif de chargement frontal selon la revendication 1, caractérisé en ce que le cosier (33) comprend une plaque de fond (331), une paire de parois latérales opposées (332, 333) se reliant à la plaque de fond, et des moyens (341 à 344) fixés aux parois latérales pour limiter le mouvement vers le haut d'une cartouche à mémoire (20) par rapport au casier (33).

3. Dispositif de chargement frontal selon l'une quelconque des revendications 1 et 2, caractérisé en ce que la boîte de connecteur (371) comporte une partie supérieure contenant l'autre ouverture (372), et en ce que le casier de cartouche (33) comprend un élément de liaison arrière (314, 315) s'étendant entre les parois latérales (332, 333) et définissant une ouverture (316) destinée à recevoir une partie supérieure de la boîte du connecteur (37).

4. Dispositif de chargement frontal selon l'une quelconque des revendications précédentes, caractérisé en ce que les moyens de ressort comprennent un ressort hélicoïdal (398) monté entre le châssis (31) et le cosier de cartouche (33), et une semelle de ressort (321, 322) dans laquelle est logé le ressort.

5. Dispositif de chargement frontal selon l'une quelconque des revendications précédentes, caractérisé en ce que le casier de cartouche (33) comprend un rail (336, 337) dirigé dans la direction d'introduction d'une cartouche à mémoire pour supporter cette cartouche (20).

6. Dispositif de chargement frontal selon l'une quelconque des revendications précédentes, caractérisé en ce que les moyens de verrouillage libérables (36) comprennent un mécanisme de clé comportant une tige d'accrochage élastique (363) et un mécanisme de came associé (36b) comprenant une rainure (365) définissant le chemin de passage de la tige lorsque les mécanismes de clé et de came sont engagés.

7. Machine de jeux électroniques caractérisée en ce quelle comprend un dispositif de chargement frontal selon l'une quelconque des revendications précédentes.

8. Machine de jeux électroniques selon la revendication 7, caractérisée en ce qu'elle comporte une cartouche à mémoire (20) chargée dans le casier (33), cette cartouche à mémoire comportant une mémoire montée sur une première carte de circuit imprimé (24), cette première carte de circuit imprimé étant logée dans une boîte (21) de la cartouche à mémoire et comportant une partie de bord sortant de la boîte, cette partie de bord portant un premier ensemble de contacts électriques exposés venant en contact avec les électrodes de ressorts verticalement opposées (378, 379) de l'autre ouverture allongée (372), toute la boîte de cartouche à mémoire étant introduite dans le casier.

9. Machine de jeux selon la revendication 8, caractérisée en ce que la boîte de cartouche à mémoire (21) comporte des parties étagées opposées (22, 22') et en ce que les côtés opposés du casier (33) comprennent des segments étagés (338, 339) coopérant avec les parties étagées de la boîte pour limiter la profondeur d'introduction de la cartouche (20) dans le casier.

10. Machine de jeux selon l'une quelconque des revendications 8 et 9, caractérisée en ce que l'électrode de ressort inférieure (379) de l'autre ouverture (372) sert de point de pivot sur lequel pivote la première carte de circuit imprimé (24) lorsqu'on fait tourner le casier (33) contenant la cartouche à mémoire (20) entre la position de chargement de la cartouche et la position de fonctionnement de cette cartouche.

11. Machine de jeux électroniques selon l'une quelconque des revendications 7 à 10, caractérisée en ce que la boîte (21) comporte une partie chanfreinée (25, 25') d'un côté de celle-ci, la section transversale du côté opposé de la boîte, lorsqu'elle est inversée, étant différente de la section transversale du côté comportant la partie chanfreinée, et le casier de cartouche (33) comportant une partie intérieure inclinée (334, 335) dont

l'inclinaison est complémentaire de celle de la partie chanfreinée, pour empêcher ainsi qu'on introduise la cartouche à mémoire (20) à l'envers dans le casier de cartouche.

12. Machine de jeux électroniques selon l'une quelconque des revendications 7 à 11, caractérisée en ce que le bloc principal (10) comporte une partie en saillie (328) dirigée vers le haut et pénétrant dans une cavité (26b) de la surface de fond de la boîte (21) lorsque le casier de cartouche (33) contenant la cartouche à mémoire (20) se trouve dans la position de fonctionnement de la cartouche, de manière à empêcher ainsi l'utilisation d'une cartouche non autorisée ne comportant pas cette cavité.

13. Machine de jeux électroniques selon la revendication 12, caractérisée en ce que la partie en saillie (328) passe à travers une ouverture (353) du casier de cartouche (33).

14. Machine de jeux électroniques selon l'une quelconque des revendications 12 et 13, caractérisée en ce qu'une autre cavité (26a) est formée dans la surface supérieure de la boîte (21) à l'opposé de la première cavité (26b) indiquée ci-dessus, ces cavités formant des parties de pincement qu'on peut pincer entre les doigts de la main pour faciliter l'introduction de la cartouche à mémoire (20).

15. Machine de jeux électroniques selon l'une quelconque des revendications 7 à 13, caractérisée en ce que la boîte (21) comporte des parties étagées (22, 22') dans ses côtés opposés, ces parties étagées coopérant avec des parties étagées complémentaires (338, 339) du casier de cartouche (33), de manière à limiter la profondeur d'introduction de la cartouche à mémoire (20) dans le casier de cartouche.

FIG.1A

FIG.1B

FIG.2

FIG.3

# F I G. 4

# F I G. 5

## F I G. 6

## F I G. 7

F I G. 8

F I G. 9

# F I G.10